(19) Europäisches Patentamt
European Patent Office
Office européen des brevets

(11) **EP 4 475 637 A1**

(12) **EUROPEAN PATENT APPLICATION**

(43) Date of publication:
**11.12.2024   Bulletin 2024/50**

(21) Application number: **23305908.8**

(22) Date of filing: **07.06.2023**

(51) International Patent Classification (IPC):
**H05K 3/00** *(2006.01)*     **H05K 3/40** *(2006.01)*
**H05K 3/42** *(2006.01)*

(52) Cooperative Patent Classification (CPC):
**H05K 3/0035;** H05K 3/0038; H05K 3/4069;
H05K 3/421; H05K 2201/09527; H05K 2201/09563;
H05K 2201/09827; H05K 2201/09863;
H05K 2203/107; H05K 2203/1476; H05K 2203/1572

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicants:
• **Mitsubishi Electric R&D Centre Europe B.V.**
**1119 NS  Schiphol Rijk Amsterdam (NL)**
Designated Contracting States:
**FR**
• **MITSUBISHI ELECTRIC CORPORATION**
**Chiyoda-ku**
**Tokyo 100-8310 (JP)**
Designated Contracting States:
**AL AT BE BG CH CY CZ DE DK EE ES FI GB GR HR HU IE IS IT LI LT LU LV MC ME MK MT NL NO PL PT RO RS SE SI SK SM TR**

(72) Inventors:
• **PICHON, Pierre-Yves**
**35708 RENNES CEDEX 7 (FR)**
• **MORAND, Julien**
**35708 RENNES CEDEX 7 (FR)**
• **PERRIN, Rémi**
**35708 RENNES CEDEX 7 (FR)**

(74) Representative: **Plasseraud IP**
**104 Rue de Richelieu**
**CS92104**
**75080 Paris Cedex 02 (FR)**

(54)     **PCB VIA DESIGN FOR POWER ELECTRONIC APPLICATIONS AND METHOD FOR MANUFACTURING**

(57)     Circuit board comprising at least one epoxy-based composite material layer (130), at least two conductive layers or tracks (110, 120) on opposite sides of said epoxy-based composite material layer (130) and first metallized vias (140) connecting said conductive layers or tracks (110, 120), wherein at least some of said vias comprise a metallized barrel (141, 141') ending with at least one flared end (β, 142') at a junction between said metallized barrel and one of said conductive layers or tracks (110, 120).

FIG. 4B

## Description

### Technical Field

The present disclosure concerns the field of PCB manufacturing and more particularly manufacturing of PCB vias.

### Background Art

It is known to provide via holes in PCBs such as multi layers PCBs.

Among other methods, laser drilling creates precise holes on a PCB to establish connections between different layers. Laser drilling techniques ensure accuracy even when dealing with the smallest of via sizes found in PCBs as laser drilling uses highly concentrated laser energy for drilling through vaporizing a hole.

In commercial production, there are two laser technologies that can be used for laser drilling. The wavelength of $CO2$ laser is in the far infrared band, and the wavelength of ultraviolet laser is in the ultraviolet band. The main difference in between those two types, is mostly coming from the capability of the UV beam to drill through metal layers whereas the $CO2$ is only drilling through organic material. Thus, $CO2$ laser is widely used in the fabrication of industrial micro via of printed circuit board. The diameter of micro via is required to be greater than 100 $\mu$m. To produce these large aperture holes, $CO2$ laser has a very high productivity, because the time required for making large aperture holes is very short. UV laser technology is widely used in the fabrication of micro holes with diameter less than 100 $\mu$m. with the use of micro circuit diagram, the aperture can be even less than 50 $\mu$m.

Several methods are known:
in single-pulse laser drilling, a single shot of laser beam is fired at the material to create the required hole. In this method, both the source of the laser and the work material are kept static.

In percussion drilling, a series of laser pulses are shot at the work material repeatedly. During this process, there is no relative motion between the laser beam and the workpiece. This form of laser drilling effectively creates deeper and precise holes with smaller diameters as compared to single-shot laser drilling. In this process, a specific power output is chosen to control melting and vaporization so as to generate a drilled hole with accurate dimensions.

Trepanning is the process in which a laser beam is guided around a predefined locus. This locus is the center of the via to be drilled. It is used in situations where the diameter of the via to be cut is larger than the laser beam diameter. The accuracy of the via is determined by the movement of the beam.

Helical laser drilling is a method in which the laser beam follows a helical path for movement while rotating about its own axis with respect to the workpiece. A dove prism controls the movement of the laser beam.

The advantage of helical drilling is to provide a fully cylindrical hole, whereas in percussion drilling, the process is faster, but a conical shaped hole is generated.

After the drilling process, a metallization process is realized through copper plating and chemical etching to metallize the hole barrel and provide an electric path between layers of the PCB .

State of the art processes to deposit metallic layers selectively on some areas of semiconductor chips or on a copper surface of a PCB are photolithographic processes based on subtractive transfer or additive transfer:
In a subtractive transfer process:
First, a continuous film of homogeneous thickness of metal is deposited using deposition methods, typically a Physical Vapor Deposition (PVD) method such as sputtering or evaporation.

Then, an etch resist layer is deposited on the metal surface except where the metal layer is unwanted. This is typically done using a photolithographic process.

Finally, the exposed metal surfaces are removed using wet etching and the etch resist layer is removed

In an additive transfer process:
First, one or two etch resist layers are deposited selectively on the surfaces where a metal layer is not wanted.

Then, a homogeneous layer of metal is deposited over both the etch resist layer and the final metallization surfaces.

Finally, the etch resist layer is removed, resulting of the peel-off of the metal layer from the unwanted surface.

In example, copper deposition prior to a subtractive transfer process or during an additive transfer process may require requires three process steps (A-C):

    a. Copper deposition through:

        i. deposition of a TaN/Ta diffusion barrier to protect the semiconductor chip from reaction with Cu. TaN can provide good adhesion onto the dielectric, and Ta offers good wettability with the Cu seed layer. Alternatives are Ti-based (Ti/TiN stacks) and Ru-based layers.

ii. Deposition of a Cu seed layer to generate nucleation sites for bulk Cu growth (typically done by PVD-sputtering).

b. deposition of bulk Cu by electroplating (ECP). ECP process is performed by immersing the wafers in a solution containing cupric ions, sulfuric acid, and trace organic additives. By applying an electric current, Cu ion (Cu+2) is reduced to Cu, which deposit onto the seed layer

c. chemical mechanical polishing of the excess copper, where rotating pads are used to planarize the surface and remove the excess Cu.

Alternatively to Cu deposition by seed layer deposition followed by electroplating, other processes may be used: Physical Vapor Deposition (PVD), Chemical vapor deposition (CVD), laser reflow, Atomic Layer Deposition (ALD), among which the CVD methods are the most widely used in the industry (evaporation and sputtering). Note that in the case of manufacturing of complex structures (i.e. different as power die plating, where a homogeneous layer thickness is deposited) the biggest challenge of the sputtering process is to achieve a good step coverage in high aspect ratio structures such as vias. Other techniques like ionized PVD or ALD show better step coverage properties than sputtering.

When the PCB is complete with its layers, copper tracks and vias, during temperature cycling of a traditional PCB, the expansion and contraction in the z direction (z-direction is defined as the cross-plane of the PCB) is much higher than that in the inplane (x-y) direction because of the higher coefficient of thermal expansion (CTE) of the epoxy/glass fiber composite providing the insulating layers in this direction. The low CTE glass fiber constrains the board in the x-y plane but not through the thickness which may expand and contract. Thus, stress build up in the copper vias such as known Plated Through Hole structures (PTH) may cause cracking to occur near the center of the barrel of such vias.

Documents y.-L. Cheng, C.-y. Lee, y.-L. Huang, "Copper Metal for Semiconductor Interconnects", in: Noble Precious Met. - Prop. Nanoscale Eff. Appl., 2018. https://doi.org/10.5772/intechopen.72396 and B. Birch, "Troubleshooting Microvia Failures", (2020) 0-12. https://doi.org/10.13140/RG.2.2.24717.77281 describe the impact of the large expansion of a dielectric in the z direction due to temperature and its impact on the different copper structures in the PCB : issues occurs most likely for structures having one or several of the following characteristics :

a. Structures that are longer in the z direction, such as PTH. Failure is most likely to occur for structures that are longer in the z direction. The reason for this is because in first approximation the strain in the copper structure is proportional to $\Delta CTE.\Delta T.l_z$, ($\Delta CTE$: CTE difference between copper and dielectric in the z direction; $\Delta T$: temperature change from stress-free state; $l_z$: length of the copper structure in the z direction). and thus, is proportional to the length of the structure $l_z$ in the z direction.

b. At the interconnection between these structures and copper sheets. Interconnections between via structures and copper sheets involve the formation of a corner or sharp angle, which in general is a locus of stress concentration.

Those stress problems may not be of significant importance in state-of-the art application of PCB designs, however in the case of the introduction of PCB materials in power electronics applications, higher temperature swings, higher maximum junction temperature, and higher number of cycles during the product life result in higher stress magnitudes and faster damage accumulation, which cause fatigue fractures at the stress concentration zones of the via structures. This is particularly the case when wide band gap chip materials are used, which enable higher maximum junction temperature operation.

Another problem is the insufficient reliability of copper vias due to stresses in the x and y directions (additionally to the z direction) when a power semiconductor chip or a passive component is embedded in a PCB laminate. Power semiconductors are made of Si or SiC which are materials with CTE significantly lower than both copper and the epoxy laminate:

Silicon Si has a CTE of about 3 ppm/K and a Young modulus around 130-188 GPa and silicon carbide SiC has a CTE of about 4 ppm/K and a Young modulus around 300-700 GPa.

Similarly, example of passive components are MnFe2O4 ferrite (magnetic) with a CTE of about 11-12 ppm/K, ceramic (capacitor, resistor) with a CTE of about 6-8 ppm/K, silicon (capacitor) about 3 ppm/K.

Thus, by comparison with the in-plane (x-y) CTE of copper and epoxy resin/glass fiber laminate composite sheets, which are matched since $CTE_{epoxy\ composite} \approx CTE_{Cu} \approx$ 18ppm/K, the CTE of power semiconductors and passive components is significantly lower, thus generating significant x and y stress components.

The introduction of semiconductor chips or passive components with low CTE values in a state-of-the art PCB laminate can thus result in more significant stresses at the copper vias and make them more prone to failure by fatigue crack propagation. In particular the presence of sharp corners between the vias and the copper sheets, combined with the addition of thermomechanical stresses in the x-y plane, can result in quicker fatigue crack propagation between the vias and the copper sheet compared to a situation without a semiconductor chip or a passive component, and finally separation between the vias and the copper sheet.

Thus, failure of vias may result from cracks that initiates at the corner between copper metallization and via pillars and there exists a higher likelihood of failure at the interface between chip metallization layers and the first row of vias, than between the first rows of vias and next metallization layers, or between next metallization layers and next row of vias.

State of the art via design applied in the case of embedded semiconductor chips or passive components does not have appropriate geometry to withstand additional shear stresses in the x-y plane during thermomechanical cycling.

**Summary**

The present disclosure provides an improved via configuration to to reduce fatigue crack propagation rate.

More precisely, the present disclosure proposes a circuit board comprising at least one epoxy-based composite material layer, at least two conductive layers or tracks on opposite sides of said epoxy-based composite material layer and first metallized vias connecting said conductive layers or tracks, wherein at least some of said vias comprise a metallized barrel ending with at least one flared end at a junction between said metallized barrel and one of said conductive layers or tracks.

The proposed via design provides a reduced propagation rate of cracks at the vias locations due to a reduced stress caused in case of temperature cycling of the PCB. This is rendered possible with the flared end or the flared ends created at both ends of the vias which reduce the stress concentration at the locations where difference of CTE between copper and the PCB epoxy insulating layer or layers occurs.

Preferably, said flared end is provided with a first angle $\alpha 1$ defined as the angle between the via barrel and the flared end, in the range $0<\alpha 1<45°$, a second angle $\alpha 2$ defined as the angle between the conductive layer and the flared end, in the range $0<\alpha 2<45°$, and a mean curvature (143) radius R1 of the flared end having a modulus |R1| greater or equal than 5 $\mu$m.

These ranges are well adapted to provide a reduced stress at the junction of the vias with the layer to which these are connected.

In a specific embodiment, $\alpha 2=\pi-\alpha 1$. In such embodiment, the flared base is diagonal with respect to a barrel of the via and the conductive layer to which the via is connected.

This provides a simple design where the via may be diabolo shaped between two conductive layers.

The circuit board may comprise at least one embedded component and one of said conductive layers may be a junction layer with a conductive pad of said embedded component.

This improves the manufacturing of PCBs with embedded dies.

Said composite material having a first coefficient of thermal expansion in an in-plane direction $CTE_{xy}$, and having a second coefficient of thermal expansion in an out-of-plane direction $CTE_z$, while said conductive layers or tracks being copper layers or tracks with a $CTE_{cu}$ said flared end is calculated to limit stress to about 300 MPa at a junction of said flared end and said copper layer under a temperature change of 100 °K.

This keeps stress of copper metallized vias below the yield strength of copper.

The circuit board may comprise at least one further composite material layer above or under one of said conductive layers or tracks.

This is the case in multilayers PCBs.

The present disclosure also concerns a method for manufacturing a circuit board as disclosed, comprising making said vias through forming holes in said epoxy based composite material in a direction perpendicular to said conductive layers using a laser beam configured for drilling said holes with a barrel, providing at least one flared end at a top and/or at a bottom of said barrel and comprising filling said holes to provide said vias.

Forming said holes may be done with adjusting a focal point of said laser beam at different heights of said holes to create said holes with a diabolo shape providing flared ends at both ends of said vias.

Said flared ends may be rounded through the metallization process of the vias.

The method may comprise for at least some of said vias, providing a basement through an additive or subtractive metallization process on a conductive layer or track on a substructure, laminating an epoxy layer on said conductive layer or track with basement, forming a hole and filling said hole on top of said basement to form said metallized via positioned on top of said basement, said basement providing a flared base for said via.

Providing said basement may comprise:

  a. Selectively depositing at least one etch resist layer on the surface of the conductive layer or track where a metal layer should not be deposited around surfaces to be metallized;
  b. Depositing a homogeneous layer of metal over both the etch resist layer and the surfaces to be metallized;
  c. removing the etch resist layer, resulting of the peel-off of the metal layer from the surfaces where a metal layer should not be deposited.

The method may comprise depositing a conductive precursor layer or track precursor layer, depositing on said precursor layer an etch resist layer at a location where a basement is to be provided, chemically etching said precursor layer to make said conductive layer or track, removing said etch resist layer to uncover said basement, laminating a further epoxy layer on said conductive layer or track, forming a hole, metallizing said hole and metallizing a further conductive layer or track and filling said hole on top of said basement to form said metallized via positioned on top of said basement, said basement providing a flared base for said via.

The method may comprise making a hole for providing a via having flared ends at a top and bottom of said barrel through rotating a laser beam inclined with respect to said hole axis with an angle β of 20°.

The method may comprise drilling a reduced diameter hole with a laser beam perpendicular to a lamination to be drilled, further drilling of said hole with rotating said laser beam at several angular positions around said axis with said laser beam being inclined with respect to a hole axis with increasing angles β1, β2, β3, said method comprising further metallizing said via having flared ends at a top and a bottom of said barrel.

In such case a diameter of said laser beam may be less than half of said diameter of said hole.

**Brief Description of Drawings**

Other features, details and advantages will be shown in the following detailed description and on the figures, on which:

Figure 1 is a schematic lateral cut view of examples of stress locations in vias;
Figure 2 is a lateral cut view of a PCB part with embedded component, vias and conductive track;
Figures 3A and 3B are enlarged views of crack positions in figure 2;
Figures 4A, 4B and 4C are schematic lateral cut views of embodiments of the present disclosure;
Figure 5 is a schematic view of a step of a first method embodiment;
Figures 6A to 6G are schematic views of steps of a second method embodiment;
Figure 7 is a schematic view of a step of a fourth method embodiment;
Figures 8A to 8E are schematic views of steps of a fifth method embodiment;
Figures 9 and 10 show charts of stress versus via end radiuses for two configurations of vias.

**Description of embodiments**

As discussed above, the introduction of sharp corners in structures submitted to a load result in stress concentration. For an idealized, infinitely sharp corner (i.e., with a radius of curvature R that tends to 0), and in the framework of linear elastic fracture mechanics a stress singularity arises with stresses that tend to be infinitely high as the corner is approached. When the distance from the corner is r, the stresses increase as $\sigma_{ij} \propto r^{\lambda}$, with $\lambda$ that depends on the materials and on the geometry but that is generally in the order of $\lambda = 0.5$.

$\sigma_{ij}$ are the stress tensor components which are inversely proportional to the distance from the corner r: $\sigma_{ij} = K/r^{\lambda}$ where K is a proportionality constant, and $\lambda$ has a typical value of 0.5. This equation thus demonstrates that stresses rise significantly as the neighborhood of a sharp corner.

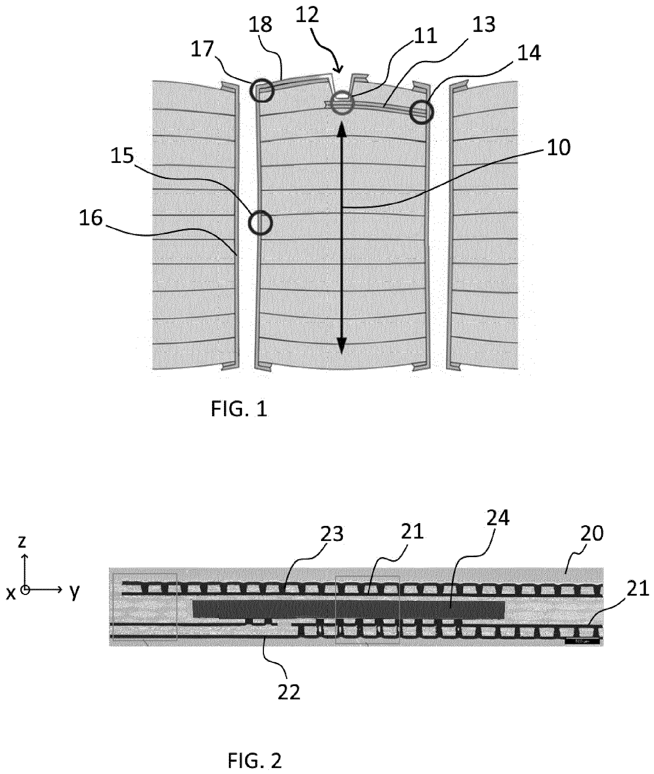

In this regard, figure 1 shows in an example of prior art design stress locations caused in case of a z-axis expansion 10. A first stress location 11 is the interconnection of a microvia 12 and an embedded track 13, a second stress location 14 is in track interconnection with a plated through hole barrel, a third stress location 15 stands in said plated through hole barrel 16 and a fourth stress location 17 is found at corners between the barrel and a flange 18 of said plated through hole.

In practical cases an infinitely sharp corner is not realized (for manufacturing and tolerance reasons), and the corner has a radius of curvature which is usually about 0.5 μm. The actual stresses at the corner are proportional to the remote stresses and increased by a factor $R^{-k}$, where k depends on the geometry, but is generally close to $k = 0.5$, where the remote stresses may be described by $\Delta CTE \cdot \Delta T \cdot l$ in the thermomechanical case of interest here.

This is the case for vias located between copper layers or copper tracks and in case of PCBs with embedded components such as semiconductor chips with vias between a connecting pad of the components and a copper layer.

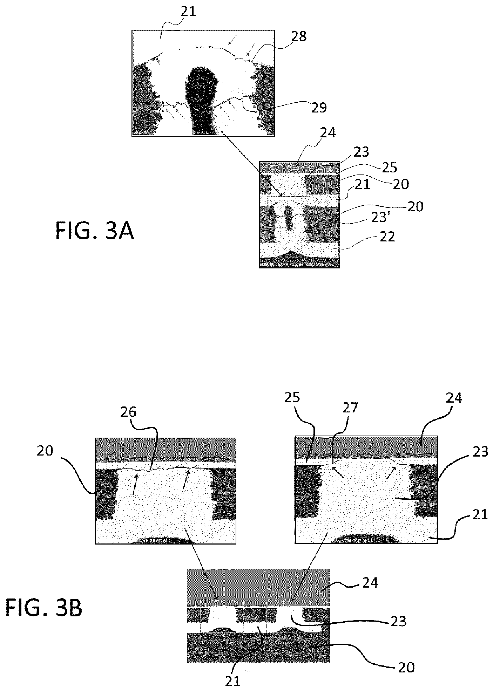

An example of PCB with embedded semiconductor chip or die 24 is given in figure 2. In this example vias 23 are made between tracks 21, 22 or between a track 21 and the embedded chip having a connecting layer 25, Typical examples of such failures are shown in Figure 3A and Figure 3B with cracks 28 between a via 23' top and track 21 or cracks 29 in the via barrel in figure 3A and cracks 26, 27 between the top of a via 23 and a conductive layer 25 of component 24 in figure 3B.

FEM calculations for a simplified 2D geometry gives the following results for a PCB with embedded die where two regions can be distinguished, based on the proximity with an embedded silicon die:

- A region corresponding to vias not connected to the silicon die and far from the silicon die to detect via failure due to stresses acting in the z direction of the structure,
- A region corresponding to vias connected with the silicon die permits to determine an insufficient reliability of copper vias due to stresses in the x and y directions (additionally to the z direction) when a power semiconductor chip or a passive component is embedded in a PCB laminate.

In this example, a first via having a height of 70 $\mu$m is located between a first copper layer of 50 $\mu$m and a second copper layer of 50 $\mu$m embedded in FR4 laminates and a second via having a height of 70 $\mu$m is located between the second copper layer and an embedded die conductive pad junction layer.

Plane strain conditions are assumed (i.e. this 2D geometry corresponds to a cross section through an infinitely long slab).The material properties are chosen as:

a. $CTEsi=3ppm/K$; $CTE_{Cu}=CTE_{FR4X}=18$ ppm/K; $CTE_{FR4Z}=41$ or 82 ppm/K;

b. E-modulus: Si : 116 GPa; Cu:127 GPa; FR4xy: 20.4 GPa; FR4z:15 GPa.

Linear elastic materials are assumed for simplicity. The complete system is submitted to a temperature change of 100°C. The curvature radii of all vias is varied between R=0.3 $\mu$m and R=30$\mu$m in a parametric study (2 cases: CTEFR4Y=41 or 82 ppm/K).

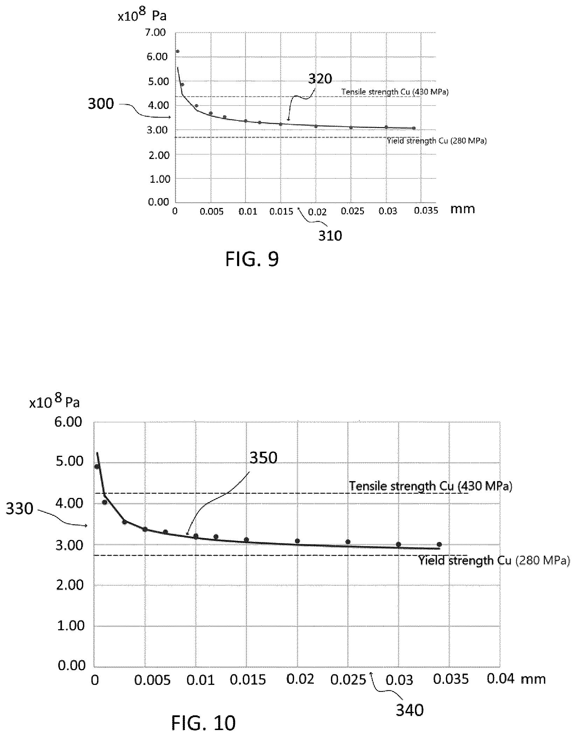

As an illustrative example of the first problem which is via failure due to stresses acting in the z direction of the structure, a calculation with CTEFR4Z= 82 ppm/K and temperature change $\Delta T$=100°C is done with reference to figure 9 showing the effect of the via curvature radius on the maximum von-mises stresses for vias located far from ab embedded component.

The continuous line 320 corresponding to the maximum Von Mises stresses in Pa 300 versus the via corner radius in mm 310 in figure 9 is fitted according to the equation:

$$\sigma = (A\Delta CTEz)(1 + \left(\frac{C}{R}\right)^{\alpha}) \qquad\qquad (1)$$

With :
A=4,1·10^{12} ; C=4,0·10^{-4} ; $\alpha$=0,4
Such figure shows that the difference of CTE in the z direction the via structure is deformed, results in stresses at the via radius. The analytical model of equation $\sigma = (A\Delta CTEz)(1 + \left(\frac{C}{R}\right)^{\alpha})$ with A=4,1·10^{12} ; C=4,0·10^{-4} ; $\alpha$=0,4 shows that the stresses are proportional to $\Delta CTEz$ (difference of CTE between FR4 and copper in the z direction and increase as R decreases with an exponent 0.4, similar to the theoretical exponent of 0.5.

Additionally, it is observed that:

a. for small via radius (R << 5 $\mu$m) the ultimate strength of copper is exceeded, demonstrating the critical effect of sharp corners on the reliability.

b. Increasing the corner radius of the via significantly reduces the stress concentration, but the values remain higher than the yield strength of copper.

In this calculation the CTE of the FR4 in the z direction is chosen as a value in the high range (CTE_{FR4Z}= 82 ppm/K). Choosing a low-range value of CTE_{FR4Z} = 41 ppm/K enables to reduce the maximum stresses below the ultimate strength for all corner radii and below the yield strength for corner radii R > 5 $\mu$m.

Thus, applying a corner radius of R > 5 $\mu$m enables to significantly increase the reliability of the system. Since the remote stress, product $\Delta CTE. \Delta T. I_z$ in equation 1, can more generally be described as $\Delta CTE \cdot \Delta T \cdot I_z$, the effect of a high difference in CTE in the z direction on the maximum stress is the same as the effect of a high $\Delta T$. The $\Delta T = 100°C$ chosen here corresponds approximately to the high range of values expected for PCBs in microelectronic applications having a range about 20°C to 120°C. Thus, these calculations confirm that the use of PCB materials at temperatures higher than 120°C is critical. However, such temperatures are present in power electronics application, where maximum temperatures of 150°C are typical, thus implying temperature swings $\Delta T > 100°C$.

Thus, the application of a corner radius R greater than 5 $\mu$m is necessary for applications where a temperature change of more than 100°C is expected, and/or where an epoxy composite laminate material with CTE_{FR4Z} > 41 ppm/K is used.

As an illustrative example of the second problem, a calculation with $CTE_{FR4Z}$= 41 ppm/K and a temperature change $\Delta T$=100°C is shown in figure 10. This figure represents the effect of the curvature radius at the corner of a via on the maximum von-mises stresses for a via located close to the embedded component. The curve 320 represents the maximum von Mises stress in Pa versus the via corner radius in mm for such plain strain modulus z for FR4 at 41 ppm according to the equation:

$$\sigma = (A\Delta CTEz + B\Delta CTEx)\left(1 + \left(\frac{c}{R}\right)^{\alpha}\right) \qquad (2)$$

With :
A=$6,5 \cdot 10^{12}$; B=$6,5 \cdot 10^{12}$; C=$4,0 \cdot 10^{-4}$ ; $\alpha$=0,4.

Because of the combination of CTE difference in z direction perpendicular to the PCB plane, and of CTE difference in the x and y directions, the in-plane directions the via structure is deformed, resulting in stresses at the via radius. The analytical model of equation (2) shows that due to the combined effects of $\Delta CTEx$ and $\Delta CTEz$ the stress increase as R decreases with an exponent 0.4, similar to the theoretical exponent of 0.5.

Additionally, it is observed that:

   a. for small via radius (R << 5 $\mu$m) the ultimate strength of copper is exceeded, demonstrating the critical effect of sharp corners on the reliability.

   b. Increasing the corner radius of the via significantly reduces the stress concentration to values close to the yield strength.

Thus, applying a corner radius of R > 5 $\mu$m enables to significantly increase the reliability of the system and is necessary for applications where a component is embedded in a epoxy composite laminated, even if a CTEz in the low range is used.

These calculations demonstrate that a higher via radius significantly reduce the maximum stresses in the two problems addressed in this invention

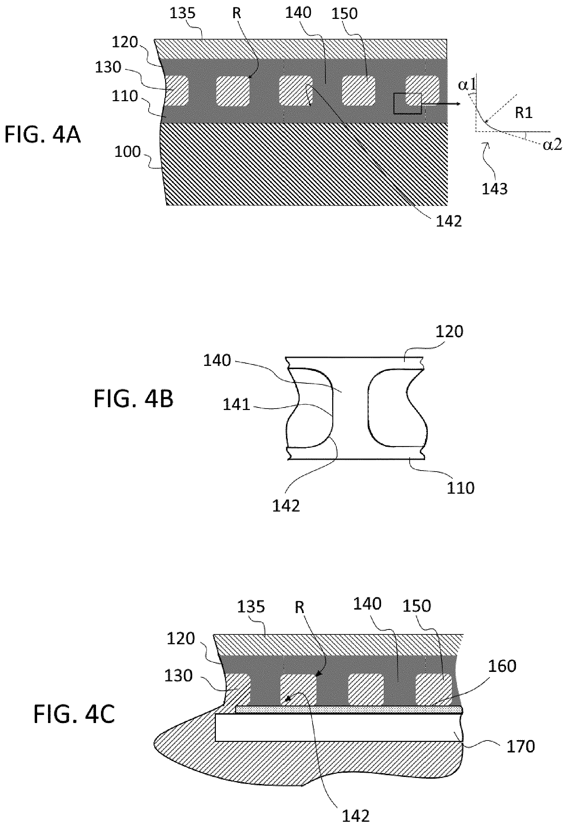

It is now referred to figure 4A that shows a base epoxy based composite material such as FR4 PCB material 100, a first conductive layer or track 110, a second conductive layer or track 120 and several vias 140 connecting said first conductive layer 110 and said second conductive layer 120.

According to the present disclosure, the vias 140 are fully metallized vias which are provided as seen in figure 4B with a barrel 141 (with an exaggerated height on the drawing) flanged ends 142 at their junction with the layers 110, 120. Back to figure 4A, the flanged ends comprise a curvature 143 with a radius R1 which is such as the modulus of R1 is greater than 5 $\mu$m to reduce the stress at the junction of the vias and the layers.

In figure 4C the vias 140 connect a conductive pad 160 of a component 170, embedded in an epoxy resin/glass fiber laminate, to a conductive layer or track 120. In such design, the vias also comprise fared ends at the junction with the conductive pad 160 and the junction with the conductive layer or track 120.

The flared end is provided with a first angle $\alpha$1 defined as the angle between the via barrel 141 and the flared end 142, a second angle $\alpha$2 defined as the angle between the flared end 142 and the conductive layer 110, 120, and a mean curvature 143 radius R1 of the flared end.

A first angle $\alpha$1 in the range 0 < $\alpha$1 < 45° is preferred,

A second angle $\alpha$2 in the range 0 < $\alpha$2 < 45° is preferred and a mean curvature radius of the flared end having a modulus |R1| greater or equal than 5 $\mu$m is also preferred.

Preferred designs comprise:

   a. a straight cut where $\alpha$1=$\alpha$2=45° and R1 tends to $\infty$;
   b. a curvature where $\alpha$1=$\alpha$2=0° and |R1| greater than 5 $\mu$m and if possible greater than 30 $\mu$m.
   c. designs where $\alpha$1 and $\alpha$2 are between such angles and in particular designs where $\alpha$2=$\pi$-$\alpha$1.

An example of application is a via structure submitted to a temperature change of 100°C or more, such as typically experienced in a power electronic environment, and/or for cases where the CTE of the FR4 material in the out-of-plane direction need to be significantly higher than 40 ppm/K, for example 82 ppm/K, for other material design constrains. For example, assuming a 2D geometry for simplicity and illustrating purposes, if the flared junction curvature radius is changed from R = 0.3 $\mu$m which is the state of the art design to R = 30 $\mu$m which is about half the distance between the copper layers for a via having a height of 70 $\mu$m and located between a first copper layer of 50 $\mu$m and a

second copper layer of 50 $\mu$m embedded in FR4 laminates as discussed above, then the maximum stresses at the corner of said vias connected between copper layers of the PCB corresponding to a temperature change of 100K from a stress-free situation is reduced from more than 600MPa which is above the ultimate strength of copper to about 300MPa, which is below the ultimate strength of copper, and close to the yield strength of copper as depicted in figure 9 Thus, the reliability of the structure is improved.

Another example of application of the present invention is a power semiconductor chip embedded in a PCB with an interconnection package consisting of copper vias with a flared junction curvature radius in the same order of magnitude as the distance between the copper layers. Thus, stress concentration is reduced significantly, and the magnitude of the stress is below the ultimate strength of copper, preferably below the yield strength of copper, such that (fatigue) crack initiation is delayed, and reliability is improved.

As another example of the present invention, assuming a 2D geometry for simplicity and illustrating purposes, if the flared junction curvature radius is changed from Rc = 0.3 $\mu$m (state of the art design) to Rc =30 $\mu$m, then the maximum stresses (at the corner) of vias connected to the semiconductor die corresponding to a temperature change of 100°K from a stress-free situation is reduced from about 490 MPa (which is above the ultimate strength of copper) to about 300 MPa, which is below the ultimate strength of copper, and close to the yield strength of copper as in figure 10. Thus, the reliability of the structure is improved.

In reference to figure 4C, the circuit board may comprise at least one further composite material layer 100, 135 above or under one of said conductive layers or tracks but may also comprise further conductive and composite material layers.

The methods for manufacturing circuit boards comprising such vias with flared ends comprise forming holes in said epoxy based composite material in a direction perpendicular to said conductive layers using a laser beam.

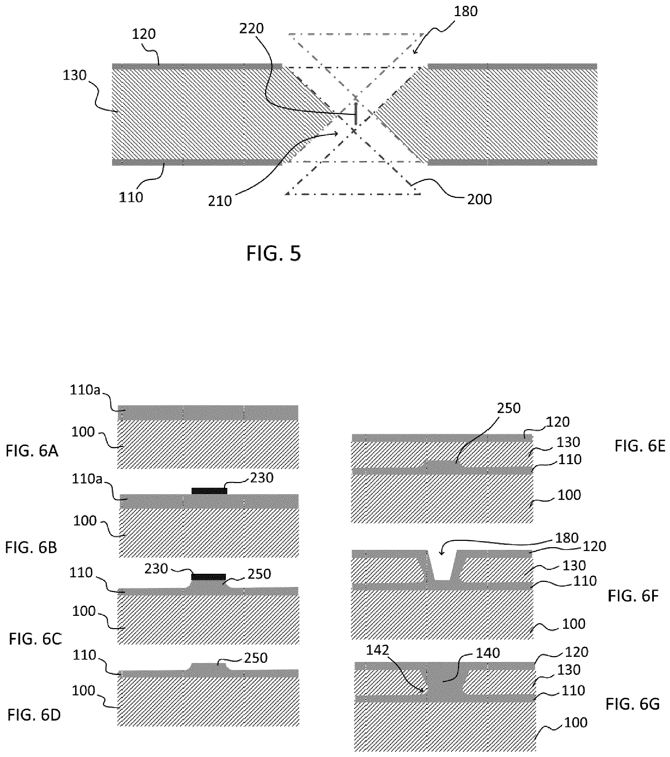

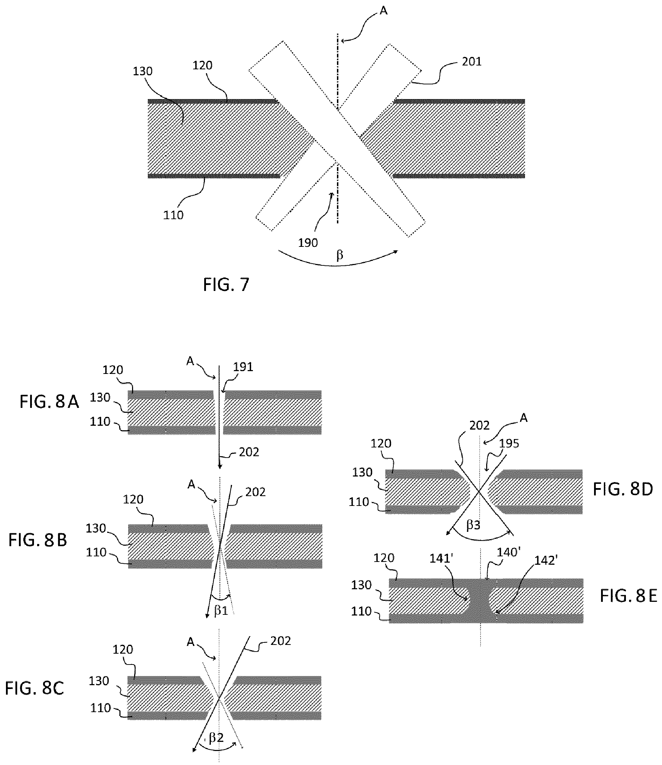

In figures 5 and 8 laser beams 200, 201 are configured for drilling said holes with a barrel, providing at least one flared end at a top and/or at a bottom of said barrel.

In figure 5, said forming holes is done with adjusting a focal point 210 of a laser beam 200 at different heights 220 of said holes to create said holes with a diabolo shape providing flared junction ends at both ends of said vias. The flared junction ends may be rounded through a metallization process of the vias.

Forming the hole may be done either by firing laser beams from one side of the via location only or by firing laser beams from one side of the via location, and then firing other laser beams from the other side of the via location.

In a further realization mode, the method may comprise, for at least some of said vias, providing a basement 250 through a subtractive metallization process starting from a thick conductive layer or track 110 on a substructure 100 as in figures 6A to 6D, laminating an epoxy layer 130 on said conductive layer or track 110, as in figures 6E, forming a hole 180 and metallizing such, as in figures 6F, and filling said metallized hole on top of said basement to form said metallized via 140 positioned on top of said basement 250 as in figure 6G, said basement providing a flared base 142 for said via.

In figure 6A to 6D providing said basement 250 comprises depositing a conductive precursor layer or track precursor layer 110a in figure 6A, depositing on said precursor layer an etch resist layer 230 at a location where a basement 250 is to be provided as in figure 6B, chemically etching said precursor layer to make said conductive layer or track 110 as in figure 6C where the basement 250 remains with the etch resist layer 230, removing said etch resist layer 230 to uncover said basement 250 as in figure 6D.

Another possible method as in figure 7 comprises making a hole 195 through rotating a laser beam 201 inclined with an angle $\beta$ with respect to an axis A of said hole.

Another possible process for providing a via having flared ends 142' at a top and bottom of a barrel 141' through making a hole in a PCB with a laser may comprise rotating a laser beam 202 of a width less than half of said diameter of said hole inclined with respect to said hole axis A with an increasing angle $\beta$, $\beta1$, $\beta2$ of 10° to 30°.

This may comprise drilling a reduced diameter hole 191 with a laser beam 202 perpendicular to a lamination 130 and copper layers 110, 120 to be drilled as in figure 8A, further drilling said hole with rotating said laser beam 202 at several angular positions around said axis with said laser beam 202 being inclined with respect to a hole axis A with an increasing angle $\beta1$, $\beta2$, $\beta3$ of 20° to 45° as in figures 9B, 9C, 9D and then metallizing said hole to provide a via 140' having flared ends 142 at a top and a bottom of said barrel 141'.

The above description shows non-limiting examples of the invention object of the appended claims. In particular the described methods are only possibilities to manufacture the vias object of the appended claims.

## Claims

1. Circuit board comprising at least one epoxy-based composite material layer (130), at least two conductive layers or tracks (110, 120) on opposite sides of said epoxy-based composite material layer (130) and first metallized vias (140) connecting said conductive layers or tracks (110, 120), wherein at least some of said vias comprise a metallized barrel (141, 141') ending with at least one flared end (β, 142') at a junction between said metallized barrel and one of said conductive layers or tracks (110, 120).

2. Circuit board according to claim 1, wherein said flared end is provided with a first angle $\alpha1$ defined as the angle between the via barrel and the flared end and in the range $0<\alpha1<45°$, a second angle $\alpha2$ defined as the angle between the flared end and the conductive layer, and in the range $0<\alpha2<45°$, and a mean curvature (143) radius R1 of the flared end having a modulus |R1| greater or equal than 5 μm.

3. Circuit board according to claim 2, wherein $\alpha2=\pi-\alpha1$.

4. Circuit board according to claim 1, 2 or 3, comprising at least one embedded component (170) and wherein one of said conductive layers (110) is a junction layer with a conductive pad (160) of said embedded component (170).

5. Circuit board according to any one of the preceding claims wherein said composite material (100) having a first coefficient of thermal expansion in an in-plane direction $CTE_{xy}$, and having a second coefficient of thermal expansion in an out-of-plane direction $CTE_z$, while said conductive layers or tracks being copper layers or tracks with a $CTE_{cu}$ said flared end is calculated to limit stress to about 300 MPa at a junction of said via flared end (142, 142') and said copper layer under a temperature change of 100 °K.

6. Circuit board according to any one of the preceding claims comprising at least one further composite material layer (100, 135) above or under one of said conductive layers or tracks.

7. Method for manufacturing a circuit board according to any one of claims 1 to 6, comprising making said vias (140, 140') through forming holes (180, 190) in said epoxy based composite material (130) in a direction perpendicular to said conductive layers (110, 120) using a laser beam (200) configured for drilling said holes with a barrel, providing at least one flared end at a top and/or at a bottom of said barrel and filling said holes to provide said vias.

8. Method according to claim 7 wherein said forming holes is done with adjusting a focal point (210) of said laser beam at different heights (220) of said holes to create said holes with a diabolo shape providing flared ends at both ends of said vias.

9. Method according to claim 8 wherein said flared end are rounded through metallization of the vias.

10. Method according to claim 7 comprising for at least some of said vias, providing a basement (250) through a subtractive metallization process on a conductive layer or track (110) on a substructure (100), laminating an epoxy layer (130) on said conductive layer or track (110) with basement (250), forming a hole (180) and filling said hole on top of said basement to form said metallized via (140) positioned on top of said basement (250, 250'), said basement providing a flared base (142) for said via.

11. Method according to claim 7 comprising depositing a conductive precursor layer or track precursor layer (110a), depositing on said precursor layer an etch resist layer (230) at a location where a basement (250) is to be provided, chemically etching said precursor layer to make said conductive layer or track (110), removing said etch resist layer (230) to uncover said basement (250), laminating a further epoxy layer (130) on said conductive layer or track (110), forming a hole (180), metallizing said hole and metallizing a further conductive layer or track (120) and filling said hole on top of said basement to form said metallized via (140) positioned on top of said basement (250), said basement providing a flared base (142) for said via.

12. Method according to claim 7 comprising making a hole (195) for providing a via (140') having flared ends (142') at a top and bottom of said barrel (141') through rotating a laser beam (201, 202) inclined with respect to said hole axis (A) with an angle β, β1, β2 of 10° to 30°.

13. Method according to claim 12 comprising drilling a reduced diameter hole (190) with a laser beam (202) perpendicular to a lamination (130) to be drilled, further drilling of said hole with rotating said laser beam at several angular positions around said axis with said laser beam (202) being inclined with respect to a hole axis (A) with an increasing angle β1, β2, β3 of 20° to 45° wherein said method comprises further metallizing said via having flared ends (142) at a top and a bottom of said barrel (141').

14. Method according to claim 13 wherein a diameter of said laser beam (202) is less than half of said diameter of said hole.

FIG. 1

FIG. 2

FIG. 3A

FIG. 3B

FIG. 4A

FIG. 4B

FIG. 4C

120

130

110

220

210

180

200

FIG. 5

FIG. 6A

110a

100

FIG. 6B

110a

230

100

FIG. 6C

110

230

250

100

FIG. 6D

110

250

100

250

120

130

110

100

FIG. 6E

180

120

130

110

100

FIG. 6F

142

140

120

130

110

100

FIG. 6G

FIG. 7

FIG. 8 A

FIG. 8 B

FIG. 8 C

FIG. 8 D

FIG. 8 E

FIG. 9

FIG. 10

Europäisches
Patentamt

European
Patent Office

Office européen
des brevets

# EUROPEAN SEARCH REPORT

Application Number

EP 23 30 5908

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 094 068 A1 (TDK CORP [JP]) 26 August 2009 (2009-08-26) | 1-7,10, 11 | INV. H05K3/00 |
| Y | * paragraph [0024] - paragraph [0043]; | 4,8,9,11 | |
| A | figures 1-12 * | 12-14 | ADD. H05K3/40 H05K3/42 |
| X | US 2012/213944 A1 (YAMAUCHI TSUTOMU [JP] ET AL) 23 August 2012 (2012-08-23) | 1-3,5-7, 10 | |
| Y | * paragraph [0028] - paragraph [0048]; | 4,8,9,11 | |
| A | figures 1-12 * | 12-14 | |
| Y | DE 101 25 397 A1 (SIEMENS DEMATIC AG [DE]) 19 December 2002 (2002-12-19) * paragraph [0025] - paragraph [0026]; figures 2-5 * | 8,9 | |
| A | US 2020/253050 A1 (TUOMINEN MIKAEL [FI]) 6 August 2020 (2020-08-06) * the whole document * | 1-14 | |

TECHNICAL FIELDS
SEARCHED    (IPC)

H05K

The present search report has been drawn up for all claims

| Place of search | Date of completion of the search | Examiner |
|---|---|---|
| The Hague | 30 November 2023 | Zimmer, René |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 30 5908

This annex lists the patent family members relating to the patent documents cited in the above-mentioned European search report.
The members are as contained in the European Patent Office EDP file on
The European Patent Office is in no way liable for these particulars which are merely given for the purpose of information.

30-11-2023

| Patent document cited in search report | | | Publication date | Patent family member(s) | | | Publication date |
|---|---|---|---|---|---|---|---|
| EP 2094068 | A1 | | 26-08-2009 | CN | 101516165 | A | 26-08-2009 |
| | | | | EP | 2094068 | A1 | 26-08-2009 |
| | | | | JP | 2009200356 | A | 03-09-2009 |
| | | | | US | 2009211799 | A1 | 27-08-2009 |
| US 2012213944 | A1 | | 23-08-2012 | CN | 102686049 | A | 19-09-2012 |
| | | | | JP | 2012175100 | A | 10-09-2012 |
| | | | | TW | 201242470 | A | 16-10-2012 |
| | | | | US | 2012213944 | A1 | 23-08-2012 |
| DE 10125397 | A1 | | 19-12-2002 | CN | 1511433 | A | 07-07-2004 |
| | | | | DE | 10125397 | A1 | 19-12-2002 |
| | | | | EP | 1389405 | A1 | 18-02-2004 |
| | | | | JP | 4422413 | B2 | 24-02-2010 |
| | | | | JP | 2004526577 | A | 02-09-2004 |
| | | | | KR | 20040005981 | A | 16-01-2004 |
| | | | | US | 2002190037 | A1 | 19-12-2002 |
| | | | | WO | 02096167 | A1 | 28-11-2002 |
| US 2020253050 | A1 | | 06-08-2020 | CN | 111511102 | A | 07-08-2020 |
| | | | | DE | 102020102362 | A1 | 06-08-2020 |
| | | | | TW | M597419 | U | 21-06-2020 |
| | | | | US | 2020253050 | A1 | 06-08-2020 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **L. CHENG ; C.-Y. LEE ; Y.-L. HUANG.** Copper Metal for Semiconductor Interconnects. *Noble Precious Met. - Prop. Nanoscale Eff. Appl.,* 2018, https://doi.org/10.5772/intechopen.72396

- **B. BIRCH.** *Troubleshooting Microvia Failures,* 2020, 0-12, https://doi.org/10.13140/RG.2.2.24717.77281